# FASCICULE DE BREVET EUROPEEN

(11) **EP 3 319 116 B1**
(45) Date de publication et mention de la délivrance du brevet: **29.06.2022**
(21) Numéro de dépôt: 17168357.6
(22) Date de dépôt: 27.04.2017
(51) Int. Cl.: H01L 21/60, H01L 23/49, H01L 23/552, H01L 23/66, H01L 23/31, H01L 21/56, H01L 23/00

(54) **PROCÉDÉ DE RÉALISATION D'UNE CONNEXION ÉLECTRIQUE ENTRE UNE PUCE ÉLECTRONIQUE ET UNE PLAQUE DE SUPPORT ET DISPOSITIF ÉLECTRONIQUE**
VERFAHREN ZUR HERSTELLUNG EINER ELEKTRISCHEN VERBINDUNG ZWISCHEN EINEM ELEKTRONISCHEN CHIP UND EINER TRÄGERPLATTE, UND ELEKTRONISCHE VORRICHTUNG
PROCESS FOR MAKING AN ELECTRIC CONNECTION BETWEEN AN ELECTRONIC DIE AND AN SUPPORT PLATE AND ELECTRONIC DEVICE

(30) Priorité: 03.11.2016 FR 1660622
(43) Date de publication de la demande: 09.05.2018
(73) Titulaire: STMicroelectronics (Grenoble 2) SAS, 38000 Grenoble (FR)
(72) Inventeur: LOPEZ, Jérôme, 38134 SAINT-JOSEPH-DE-RIVIERE (FR); QUERCIA, Fabien, 38160 SAINT MARCELIN (FR); HAJJI, Asma, 38140 RIVES (FR); AUCHERE, David, 38400 SAINT MARTIN D'HERES (FR)
(74) Mandataire: Casalonga

(56) Documents cités:
- JP-A- H01 248 547
- JP-A- H05 226 391
- JP-A- H06 268 100
- JP-A- 2000 058 579
- US-A1- 2004 070 065
- US-A1- 2006 097 404
- US-A1- 2010 025 864
- US-A1- 2014 103 500
- US-B1- 8 377 749

## Description

La présente invention concerne le domaine des dispositifs électroniques et plus particulièrement ceux qui comprennent des puces électroniques montées sur des plaques de support, incluant des réseaux de connexion électrique ou des grilles de connexion électrique, et des fils de connexion électrique qui relient les puces aux plaques de support.

Le document JP H06 268100 décrit un dispositif électronique dans lequel une puce est installée sur le fond d'une cavité étagée d'une plaque de support et des fils de connexion électriques relient la puce et la plaque de support. Une couche diélectrique recouvre complètement la puce, la cavité et les fils et un bloc d'encapsulation conducteur de l'électricité recouvre complètement les fils enrobés et la couche diélectrique et remplit complètement la cavité.

Le document US 2006/0097404 décrit un dispositif électronique qui comprend une puce montée sur une plaque de support et des fils de connexion électriques entre la puce et la plaque de support. Les fils de connexion électriques et les plots de connexion électriques sont enrobés d'une matière diélectrique. La puce et les fils enrobés sont complètement noyés dans un bloc épais d'encapsulation conducteur de l'électricité, formé en avant de la plaque de support.

Le document US 2014/0103500 décrit un dispositif électronique qui comprend des puces espacées montées sur une plaque de support et des fils de connexion électriques entre l'une des puces et la plaque de support, placés entre les puces. Les fils de connexion électriques et des parties des puces sont noyés dans un bloc épais d'une matière diélectrique qui est complètement noyé dans un bloc épais d'encapsulation conducteur de l'électricité, formé en avant de la plaque de support et des puces.

Dans le cas où des fils de connexion électrique transportent des signaux notamment à des fréquences élevées, ces signaux peuvent être atténués ou peuvent être perturbés par des champs électromagnétiques environnants et/ou émettent des champs électromagnétiques qui peuvent perturber l'environnement.

A l'heure actuelle, pour réduire cette difficulté, il est proposé d'adjoindre aux dispositifs électroniques des plaques métalliques de blindage, éventuellement reliées à une masse. Néanmoins, la mise en place et la connexion électrique à une masse de telles plaques métalliques de blindage, combinées avec la réalisation de blocs d'encapsulation ou à la mise en place de couvercles d'encapsulation, posent des difficultés et sont onéreuses. De plus, comme les blindages obtenus sont globaux et à distance des fils de connexion électrique, la protection électromagnétique obtenue reste insuffisante.

Différents aspects de l'invention sont définis dans les revendications annexées.

Selon un mode de réalisation, il est proposé un procédé de réalisation d'une connexion électrique entre une puce électronique et une plaque de support sur laquelle cette puce est montée, le procédé étant selon la revendication 1.

La distribution de la matière diélectrique peut être réalisée par pulvérisation.

Le procédé peut comprendre en outre les étapes suivantes :
réaliser des ouvertures dans la couche diélectrique au-dessus de plots complémentaires de connexion électrique de la puce électronique et de la plaque de support,
mettre en place un fil complémentaire de connexion électrique entre les plots complémentaires et réaliser des jonctions électriques entre les extrémités du fil complémentaire et des plots complémentaires, et
réaliser le blindage local conducteur de sorte que ce blindage local conducteur soit en contact avec le fil complémentaire de connexion électrique et/ou avec au moins l'un des plots complémentaires.

Un mode de fabrication va maintenant être décrit titre d'exemple non limitatif, illustré par le dessin annexé dans lequel :
- la figure 1 représente une vue en coupe d'un dispositif électronique en cours de fabrication, selon une étape de fabrication ;
- la figure 2 représente une vue de dessus du dispositif électronique de la figure 1 ;
- la figure 3 représente une vue en coupe du dispositif électronique en cours de fabrication, selon une étape ultérieure de fabrication ;
- la figure 4 représente une vue de dessus du dispositif électronique de la figure 3 ;
- la figure 5 représente une vue de dessus du dispositif électronique en cours de fabrication, selon une étape ultérieure de fabrication ;
- la figure 6 représente une vue en coupe du dispositif électronique en cours de fabrication, selon une étape ultérieure de fabrication, montrant le dispositif électronique obtenu ; et
- la figure 7 représente une vue de dessus du dispositif électronique de la figure 6.

Comme illustré sur les figures, un dispositif électronique 1 comprend une plaque de support 2 et une puce électronique 3, incluant des circuits intégrés, dont une face arrière 4 est fixée sur une face avant 5 de la plaque de support 2, par l'intermédiaire d'une couche de colle (non représentée).

La plaque de support 2 est en une matière diélectrique et inclut un réseau intégré de connexion électrique 6, à un ou plusieurs niveaux métalliques, qui comprend des plots avant découverts de connexion électrique 7 et 8 de la face avant 5 et qui sont situés latéralement à distance d'un flanc 9 de la puce électronique 3 et à proximité l'un de l'autre.

La puce électronique 3 comprend des plots avant découverts de connexion électrique 10 et 11 d'une face avant 12 de cette puce électronique 3, opposée à sa face arrière 4, et qui sont situés à distance du flanc 9 de la puce électronique 3, non loin des plots avant 7 et 8 de la plaque de support 2.

On va maintenant décrire des étapes en vue de réaliser des connexions électriques entre les plots 7 et 10 et, optionnellement, les plots 8 et 11, respectivement de la plaque de support 2 et de la puce électronique 3.

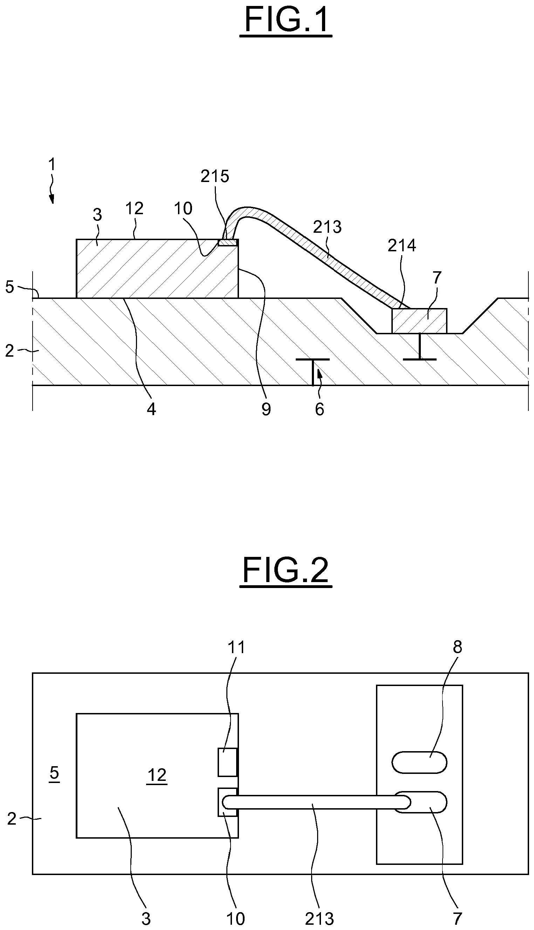

Selon une étape illustrée sur les figures 1 et 2, on met en place un fil de connexion électrique 213 entre les plots découverts de connexion électrique 7 et 10 et on réalise par soudure des jonctions électriques 214 et 215 respectivement entre les extrémités du fil de connexion électrique 213 et les plots 7 et 10.

Cette opération de mise en place des fils de connexion électrique 213 et 216 peut être réalisée à l'aide d'une machine adaptée de pose et de soudage, bien connue sous le vocable anglais de « wire bonding ».

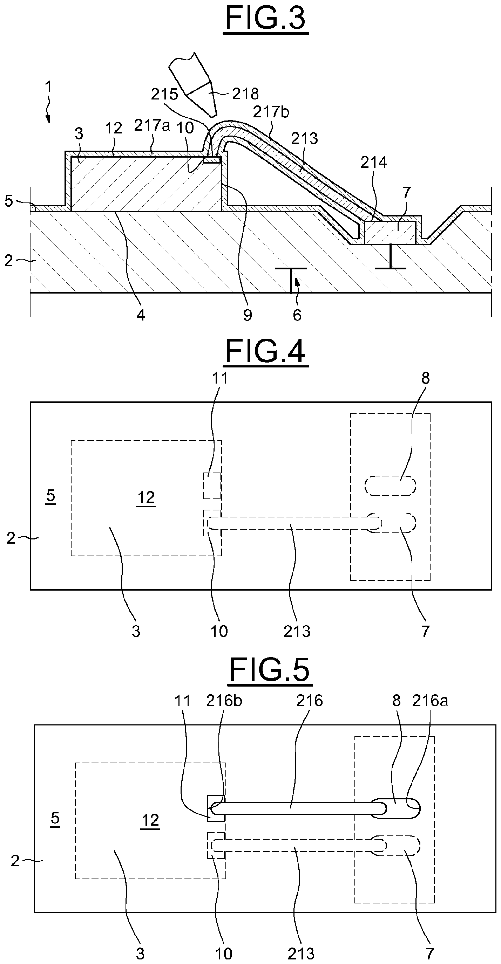

Selon une étape ultérieure illustrée sur les figures 3 et 4, on distribue une quantité déterminée d'une matière diélectrique liquide adhérente au-dessus d'une zone des faces avant 5 et 12 de la plaque de support 2 et de la puce électronique 3 et du fil de connexion électrique 213, de sorte que cette matière diélectrique recouvre au moins partiellement les faces 5 et 12, les plots 7, 8, 10 et 12 et les jonctions 214 et 215 et entoure complètement le fil de connexion électrique 213.

Après durcissement, cette matière diélectrique forme une couche diélectrique 217a au-dessus des faces avant 5 et 12 de la plaque de support 2 et de la puce électronique 3 et réalise un enrobage local diélectrique 217b qui recouvre les plots 7, 8, 10 et 12 et les jonctions 214 et 215 et qui entoure le fil de connexion électrique 213, la couche diélectrique 217a et l'enrobage local diélectrique 217b se prolongeant l'un l'autre.

Cette opération peut être réalisée par exemple à l'aide d'un outil adapté de pulvérisation comprenant une buse 218 de distribution contrôlée, apte à délivrer, sous la forme de gouttelettes, la matière diélectrique liquide, cette matière diélectrique liquide s'étendant notamment par effet de capillarité ou de mouillage. A titre de variante, cette opération peut être réalisée par immersion de l'ensemble du dispositif électronique 1 dans un bain de matière diélectrique.

Puis, la matière diélectrique liquide est durcie pour constituer la couche diélectrique 217a et l'enrobage diélectrique 217b, soit grâce à ses qualités intrinsèques de durcissement à la température ambiante ou de durcissement sous l'effet d'une source de chaleur ou de rayonnement lumineux. Par exemple, la matière diélectrique peut être une résine époxy adaptée ou bien encore un polymère de type poly-para-xylylène, communément appelé parylène.

Selon une étape ultérieure illustrée sur la figure 5, on réalise des ouvertures 216a et 216b au travers de la couche diélectrique 217a, par exemple par gravure, au-dessus des plots 8 et 11. Puis, on met en place un fil complémentaire de connexion électrique 216 entre les plots complémentaires découverts de connexion électrique 7 et 10 et on réalise par soudure des jonctions électriques respectivement entre les extrémités du fil de connexion électrique 216 et les plots 8 et 11.

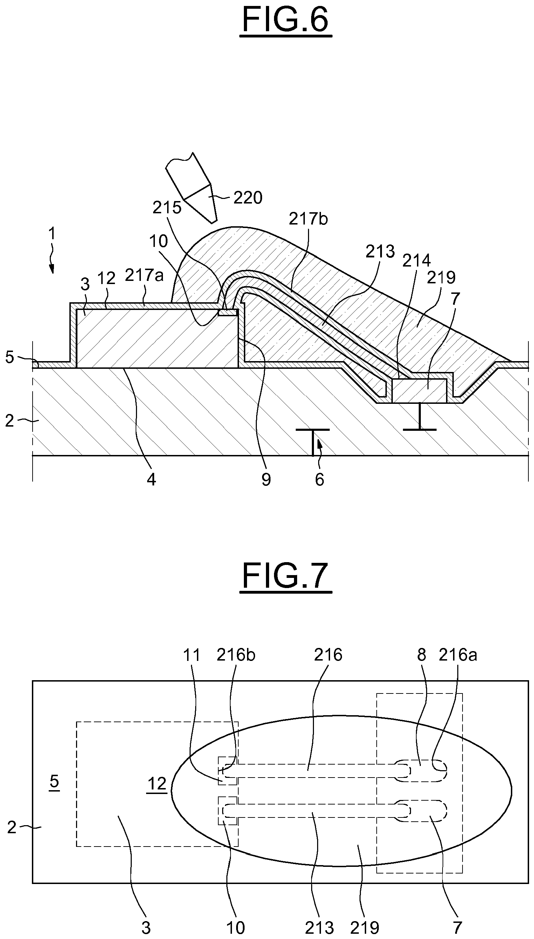

Selon une étape ultérieure illustrée sur la figure 6 et 7, on distribue localement une quantité déterminée d'une matière liquide adhérente conductrice de l'électricité au-dessus de l'enrobage diélectrique 217 et éventuellement du fil de connexion électrique 216, de sorte que cette matière conductrice entoure complètement l'enrobage diélectrique 217b et soit en contact avec le fil de connexion électrique 216 et/ou les plots 8 et 11, cette matière conductrice débordant éventuellement sur les faces avant 5 et 12 de la plaque de support 2 et de la puce électronique 3. Après durcissement, cette matière conductrice réalise un blindage local conducteur de l'électricité 219 au plus près du fil de connexion électrique 213 et relié au fil de connexion électrique 216 et aux plots 8 et 11.

Cette opération est à l'aide d'un outil contrôlé adapté comprenant une seringue 220 de distribution contrôlée, apte à délivrer au moins une goutte calibrée de la matière conductrice liquide, cette matière conductrice liquide s'écoulant notamment par effet de capillarité ou de mouillage.

Puis, la matière conductrice liquide est durcie pour constituer le blindage local conducteur 219, grâce à ses qualités intrinsèques de durcissement à la température ambiante ou de durcissement sous l'effet d'une source de chaleur ou de rayonnement lumineux. Par exemple, la matière conductrice peut être une résine époxy chargée de particules métalliques.

Le dispositif électronique 1 final est alors obtenu.

Le fil de connexion électrique 213 est destiné au transport de signaux électriques entre les plots 7 et 10 de la plaque de support 2 et de la puce électronique 3. Le blindage conducteur 219 constitue une protection électromagnétique de ces signaux électriques.

Les plots 8 et 11, reliés par le fil de connexion électrique 216, constituent des plots de masse des circuits électriques du dispositif électronique 1. Ainsi, le blindage conducteur 219, qui est relié aux plots 8 et 11 et au fil de connexion électrique 216, est relié à la masse des circuits électriques du dispositif électronique 1.

Selon une variante de réalisation, le blindage conducteur local 219 pourrait recouvrir partiellement l'enrobage diélectrique local 217b.

Selon une variante de réalisation, le fil de connexion électrique 216 pourrait être supprimé.

Bien entendu, le dispositif électronique 1 peut comprendre d'autres fils de connexion électrique 213 reliant d'autres plots 7 et 10 de la plaque de support 2 et de la puce électronique 3 et d'autres fils de connexion électrique 216 reliant d'autres plots 8 et 11 de la plaque de support 2 et de la puce électronique 3, également équipés d'enrobages diélectriques locaux 217b et de blindages conducteurs locaux 219, dont les étapes de réalisation seraient respectivement communes.

Selon une variante de réalisation, un blindage conducteur local 219 pourrait être commun à plusieurs fils de connexion électrique 213 voisins et recouvrir localement la face avant 5 de la plaque de support et/ou la face avant 12 de la puce électronique 3, de sorte que ce blindage conducteur local étendu 219 constituerait une protection électromagnétique de certains des circuits électroniques du dispositif électronique 1. Dans ce cas, un seul fil de connexion électrique de masse 216 pourrait être prévu.

Selon une variante de réalisation, la plaque de support 2 pourrait comprendre une grille métallique comprenant une plateforme sur laquelle serait montée la puce électronique 3, les fils de connexion électrique 213 et 216 reliant la puce électronique 3 à des pattes périphériques de cette grille.

## Revendications

1. Procédé de réalisation d'une connexion électrique entre
une puce électronique (3) et une plaque de support (2) sur laquelle cette puce est montée, comprenant les étapes suivantes :
mettre en place au moins un fil de connexion électrique (213) entre un plot découvert de connexion électrique (10) de la puce et un plot découvert de connexion électrique (7) de la plaque de support et réaliser des jonctions électriques entre les extrémités du fil et les plots,
réaliser une couche diélectrique en une matière diélectrique au-dessus d'une zone de la puce électronique et de la plaque de support, incluant le fil de connexion électrique, les jonctions et les plots, par distribution d'une quantité déterminée de la matière diélectrique à l'état liquide et durcissement de cette matière diélectrique, de sorte que cette couche diélectrique réalise un enrobage local diélectrique (217b) qui entoure le fil de connexion électrique et recouvre les jonctions et les plots, et
réaliser un blindage local conducteur (219) en une matière conductrice de l'électricité, qui recouvre au moins partiellement l'enrobage local diélectrique, par distribution locale d'une quantité déterminée d'une matière conductrice de l'électricité à l'état liquide, sous la forme d'une goutte calibrée qui s'écoule par effet de capillarité ou de mouillage, à l'aide d'un outil contrôlé comprenant une seringue de distribution contrôlée (220), et durcissement de cette matière conductrice, de sorte à réaliser un blindage autour du fil de connexion électrique et des jonctions.

2. Procédé selon la revendication 1, dans lequel la distribution de la matière diélectrique est réalisée par pulvérisation.

3. Procédé selon l'une des revendications 1 et 2, comprenant les étapes suivantes :
réaliser des ouvertures (216a, 216b) dans la couche diélectrique (217a) au-dessus de plots complémentaires de connexion électrique (8, 11) de la puce électronique et de la plaque de support,
mettre en place un fil complémentaire de connexion électrique (216) entre les plots complémentaires et réaliser des jonctions électriques entre les extrémités du fil complémentaire et des plots complémentaires, et
réaliser le blindage local conducteur (219) de sorte que ce blindage local conducteur soit en contact avec le fil complémentaire de connexion électrique (216) et/ou avec au moins l'un des plots complémentaires.

## Patentansprüche

1. Verfahren zur Realisierung einer elektrischen Verbindung zwischen einem elektronischen Chip (3) und einer Trägerplatte (2), auf der dieser Chip montiert ist, die folgenden Schritte umfassend:
Installieren mindestens eines elektrischen Verbindungsdrahts (213) zwischen einem unbedeckten elektrischen Verbindungskontakt (10) des Chips und einem unbedeckten elektrischen Verbindungskontakt (7) der Trägerplatte, und Realisieren von elektrischen Übergängen zwischen den Enden des Drahts und den Kontakten, Realisieren einer dielektrischen Schicht aus einem dielektrischen Material über einer Zone des elektronischen Chips und der Trägerplatte, einschließlich des elektrischen Verbindungsdrahts, der Übergänge und der Kontakte, durch Verteilung einer bestimmten Menge des dielektrischen Materials im flüssigen Zustand und Aushärtung dieses dielektrischen Materials, so dass diese dielektrische Schicht eine lokale dielektrische Umhüllung (217b) realisiert, die den elektrischen Verbindungsdraht umgibt und die Kontakte und die Übergänge bedeckt, und Realisieren einer lokalen leitenden Abschirmung (219) aus einem elektrisch leitenden Material, das die lokale dielektrische Umhüllung mindestens teilweise bedeckt, durch lokale Verteilung einer bestimmten Menge eines elektrisch leitenden Materials in flüssigem Zustand in der Form eines geeichten Tropfens, der durch Kapillar- oder Benetzungswirkung fließt, unter Verwendung eines kontrollierten Werkzeugs, das eine Spritze mit kontrollierter Verteilung (220) umfasst, und Aushärtung dieses leitenden Materials, so dass eine Abschirmung um den elektrischen Verbindungsdraht und die Übergänge realisiert wird.

2. Verfahren nach Anspruch 1, wobei die Verteilung des dielektrischen Materials durch Zerstäubung erfolgt.

3. Verfahren nach einem der Ansprüche 1 und 2, die folgenden Schritte umfassend:
Realisieren von Öffnungen (216a, 216b) in der dielektrischen Schicht (217a) über den komplementären Kontakten der elektrischen Verbindung (8, 11) des elektronischen Chips und der Trägerplatte, Einrichten eines komplementären elektrischen Verbindungsdrahts (216) zwischen den komplementären Kontakten und Realisieren elektrischer Übergänge zwischen den Enden des komplementären Drahts und den komplementären Kontakten, und
Realisieren der lokalen leitenden Abschirmung (219), so dass diese lokale leitende Abschirmung mit dem komplementären elektrischen Verbindungsdraht (216) in Kontakt steht und/oder mit mindestens einem der komplementären Kontakte.

## Claims

1. Method for making an electrical connection between an electronic chip (3) and a carrier plate (2) on which this chip is mounted, comprising the following steps of:
installing at least one electrical connection wire (213) between an exposed electrical connection pad (10) of the chip and an exposed electrical connection pad (7) of the support plate and making electrical junctions between the ends of the wire and the pads,
producing a dielectric layer made of a dielectric material over an area of the electronic chip and of the carrier plate, including the electrical connection wire, the junctions and the pads, by dispensing a determined amount of the dielectric material in the liquid state and hardening this dielectric material, such that this dielectric layer produces a local dielectric coating (217b) which surrounds the electrical connection wire and covers the junctions and the pads, and
producing a local conductive shield (219) made of an electrically conductive material, which at least partially covers the local dielectric coating, by locally dispensing a determined amount of an electrically conductive material in the liquid state, in the form of a calibrated drop which flows by capillary or wetting effect, by means of a controlled tool comprising a controlled dispensing syringe (220), and hardening this conductive material, so as to produce a shield around the electrical connection wire and the junctions.

2. Method according to claim 1, wherein the dielectric material is dispensed by spraying.

3. Method according to one of claims 1 and 2, comprising the following steps of:
producing openings (216a, 216b) in the dielectric layer (217a) above complementary electrical connection pads (8, 11) of the electronic chip and of the carrier plate, installing a complementary electrical connection wire (216) between the complementary pads and producing electrical junctions between the ends of the complementary wire and the complementary pads, and
producing the local conductive shield (219) such that this local conductive shield is in contact with the complementary electrical connection wire (216) and/or with at least one of the complementary pads.
